# EUROPEAN PATENT APPLICATION

(11) **EP 2 073 281 A1**
(43) Date of publication of application: **24.06.2009**
(21) Application number: 07150410.4
(22) Date of filing: 21.12.2007
(51) Int. Cl.: H01L 31/052, H01L 31/048

(54) **Concentration solar cell chip packaging structure and method of forming the same**

(71) Applicant: Arima EcoEnergy Technologies Corporation, Dashi Town, Taoyuan 335 (TW)
(72) Inventor: Lee, Sen-Tien, 335, Taoyuan (TW); Tzeng, Yen-Chang, 335, Taoyuan (TW)
(74) Representative: Viering, Jentschura & Partner

(57) **Abstract**

In a method of forming a concentration solar cell chip packaging structure, at least one solar cell chip 21 is mounted on an electrically conducting plate 20, and the solar cell chip 21 along with the conducting plate 20 are encapsulated in a package 22 made of a highly light-pervious and shock-absorbing polymer material. Moreover, a thin layer of low-iron, high-strength, and light-pervious material 23 is attached to an outer surface of the polymer package 22. With the above method, the concentration solar cell chip packaging structure may be formed with shortened processing time and improved processing quality to give the packaged solar cell increased light transmittance and prolonged usable life.

## Description

### FIELD OF THE INVENTION

The present invention relates to a concentration solar cell chip packaging structure, and more particularly, to a method for forming a concentration solar cell chip packaging structure with shortened processing time and improved processing quality to give the packaged solar cell increased light transmittance.

### BACKGROUND OF THE INVENTION

There are only limited resources available on the earth. Human beings are encountering with the difficulty and embarrassment of constantly consumed and gradually depleted energy resources. According to reports from energy-related journals, the exploitation of oil is estimated to terminate within next ten years. On the other hand, the use of nuclear energy would face the problem of nuclear waste disposal. Therefore, it has become a very important and pressing task to develop a new generation of energy sources. Among a variety of renewable energy technologies, the application of solar photovoltaic energy has received particularly wide attention and deemed as the currently available most reliable new energy source. Meanwhile, the solar photovoltaics enabling the use of sunlight as the new energy source has simple structure without the risk of causing recycled pollution. Therefore, the solar photovoltaic energy is referred to as clean energy. Among the viable photovoltaic technologies, concentration solar cell has gained a lot of attention due to its high energy conversion efficiency recently.

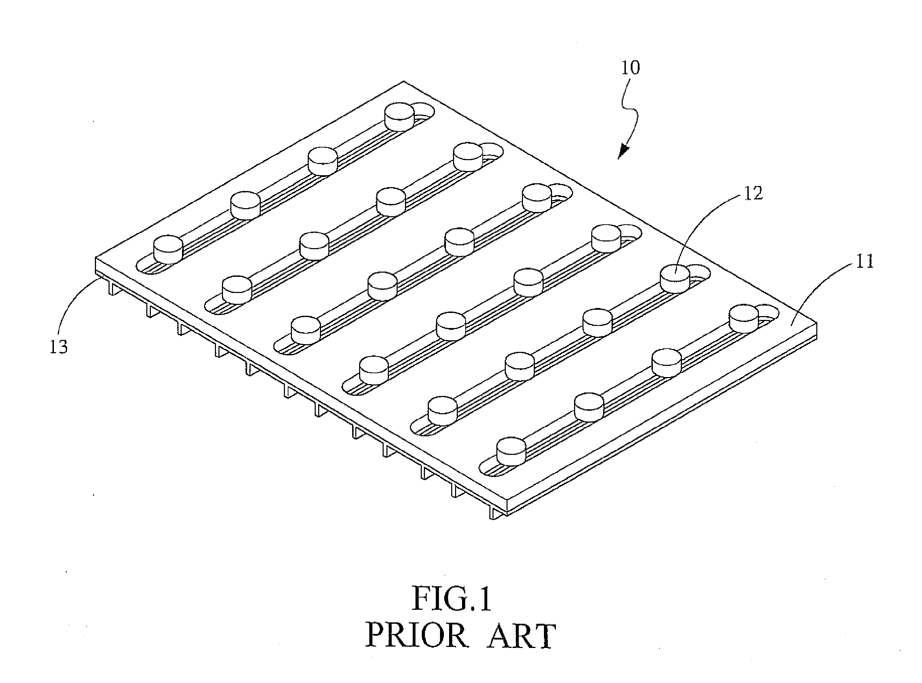

Fig. 1 shows a conventional concentration solar cell receiver plate 10, which includes an insulating thermal conductive sub-mount 11, and at least one solar cell chip 12 fixed to the insulating thermal conductive sub-mount 11. The solar cell chip 12 is encapsulated and thereby isolated from external ambience. Then, the insulating thermal conductive sub-mount 11 with one, multiple, or arrayed solar cell chips is installed on a heat sink 13. Through the contact thermal conductance of the heat sink 13, surplus heat produced by the solar cell chip 12 is carried away from the solar cell chip 12 and the insulating thermal conductive sub-mount 11.

The above-described encapsulation structure for the solar cell chip 12 has the following disadvantages:
1. The encapsulating compound is subjected to long-term exposure to air and ultraviolet irradiation, and thereby tends to become aged, yellowed, or deteriorated, resulting in insufficient incident light and poor light transmittance.
2. The encapsulation of the solar cell chip requires two times of solder reflow process and involves relatively complicated manufacturing process. That is, a solar cell module is attached to a ceramic material and sent through a reflow oven; and then, the ceramic material is further attached to an aluminum plate and sent through the reflow oven again.
3. The encapsulating compound does not have any external shielding and is directly exposed to ambience to adversely affect the usable life of the solar cell.

It is therefore tried by the inventor to develop a concentration solar cell chip packaging structure and a method for forming the same, so as to shorten the processing time, improve the processing quality, and increase the light transmittance of the packaged solar cell.

### SUMMARY OF THE INVENTION

A primary object of the present invention is to provide a concentration solar cell chip packaging structure and a method for forming the same, so that the concentration solar cell chip packaging structure may be formed with shortened processing time and improved processing quality to give the packaged solar cell increased light transmittance and prolonged service life.

To achieve the above and other objects, the concentration solar cell chip packaging structure according to the present invention includes a heat sink, a thin layer of insulating material provided on a top of the heat sink, an electrically conducting plate provided on the insulating layer, at least one solar cell chip mounted on the conducting plate, a package made of a highly light-pervious and shock-absorbing polymer material encapsulating the solar cell chip and the conducting plate, and a thin layer of low-iron, high-strength, and light-pervious material attached to an outer surface of the polymer package.

### BRIEF DESCRIPTION OF THE DRAWINGS

The structure and the technical means adopted by the present invention to achieve the above and other objects can be best understood by referring to the following detailed description of the preferred embodiments and the accompanying drawings, wherein
Fig. 1 is a top perspective view of a conventional concentration solar cell receiver plate;
Fig. 2 is a block diagram showing the forming of a concentration solar cell chip packaging structure according to a method of the present invention; and
Fig. 3 is a fragmentary sectional view of a concentration solar cell chip packaging structure according to the present invention.

### DETAILED DESCRIPTION OF THE PREFERRED EMBODIMENTS

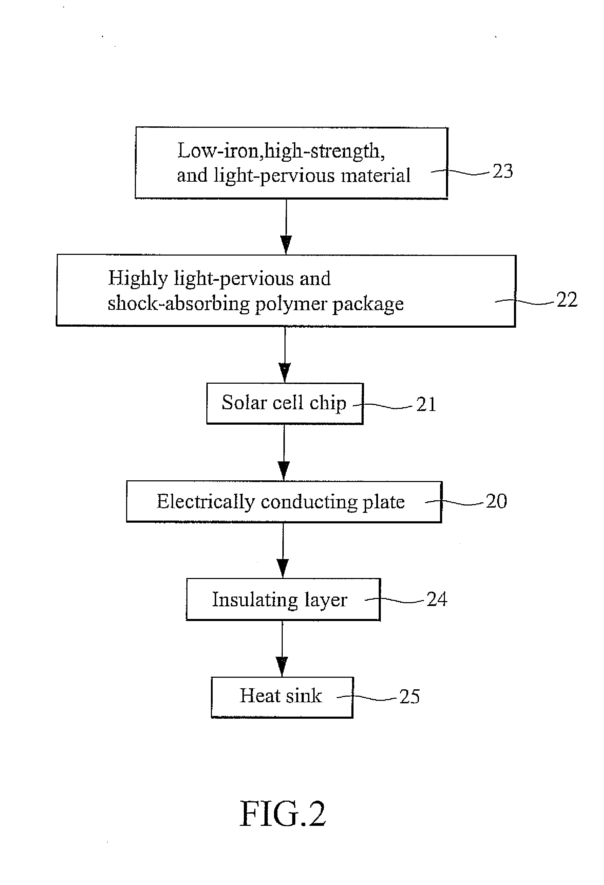

Please refer to Fig. 2 that is a block diagram showing the forming of a concentration solar cell chip packaging structure according to a method of the present invention. As shown, in the method of present invention for forming a concentration solar cell chip packaging structure, first provide a heat sink 25, and then provide a thin layer of an insulating material 24 on a top of the heat sink 25. Thereafter, provide an electrically conducting plate 20 on the insulating layer 24, and mount at least one solar cell chip 21 on the conducting plate 20. The conducting plate 20 not only supports the solar cell chip 21 thereon, but also carries wires and pins (not shown) necessary for the solar cell chip packaging structure, and the solar cell chip 21 is electrically connected to the pins. The conducting plate 20 may be made of an electrically conducting metal material, such as an aluminum alloy or a copper foil. The conducting plate 20 and the necessary wires and pins carried thereon may be integrated using a metal core printed circuit board (MCPCB) by passing through a reflow oven once only.

Then, form a package 22 using a highly light-pervious and shock-absorbing polymer material to encapsulate the solar cell chip 21 and the conducting plate 20, so as to protect the structure having been completed in the above-mentioned steps for it to focus sunlight. Chip packaging technology using a polymer package has been applied in silicon processing solar cell packaging technology for more than twenty years, and provides at least the advantages of easy operation and high stability.

After the highly light-pervious and shock-absorbing polymer package 22 has been formed to encapsulate the solar cell chip 21 and the conducting plate 20, a layer of low-iron, high-strength, and light-pervious material 23 is further formed thereon. The low-iron, high-strength, and light-pervious material 23 may be a tempered glass to contain less than 0.5% of iron, so as to obtain relatively high light transmittance and to protect the highly light-pervious and shock-absorbing polymer package 22 against direct contact with external air while effectively isolate the polymer package 22 from external moisture and dust. In the present invention, the highly light-pervious and shock-absorbing polymer package 22 may be, for example, ethylene vinyl acetate (EVA).

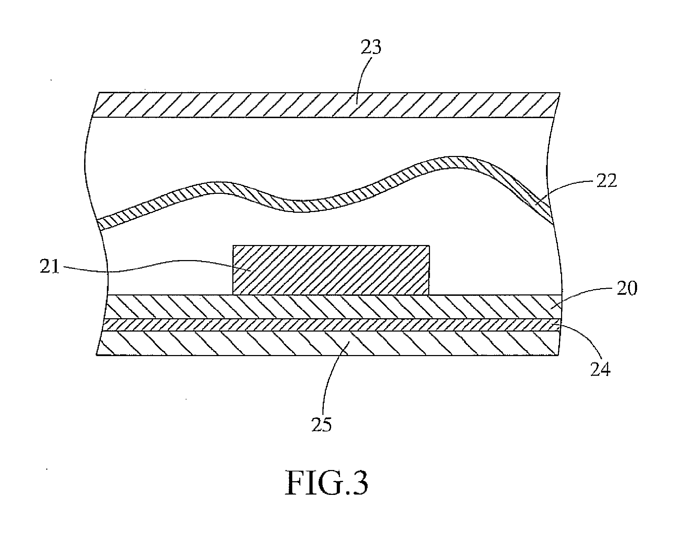

Please refer to Fig. 3. A concentration solar cell chip packaging structure formed in the method of the present invention includes a heat sink 25, a thin layer of insulating material 24 provided on a top of the heat sink 25, an electrically conducting plate 20 provided on the insulating layer 24, at least one solar cell chip 21 mounted to a top of the conducting plate 20, a package 22 made of a highly light-pervious and shock-absorbing polymer material, and a layer of low-iron, high-strength, and light-pervious material 23.

The conducting plate 20 supports the solar cell chip 21 thereon, and carries wires and pins (not shown) necessary for the solar cell chip packaging structure, and the solar cell chip 21 is electrically connected to the pins. The conducting plate 20 may be made of an electrically conducting metal material, such as an aluminum alloy or a copper foil. The conducting plate 20 and the necessary wires and pins carried thereon may be integrated using a metal core printed circuit board (MCPCB) by passing through a reflow oven once only.

The package 22 using a highly light-pervious and shock-absorbing polymer material encapsulates the solar cell chip 21 and the conducting plate 20. Due to the nature of the highly light-pervious and shock-absorbing polymer material, the package 22 may be formed into a variety of geometrical shapes for receiving sunlight irradiated thereon from all directions. The polymer package 22 may be, for example, ethylene vinyl acetate (EVA).

The low-iron, high-strength, and light-pervious material 23 is attached to an outer surface of the highly light-pervious and shock-absorbing polymer package 22, and may be a tempered glass to contain less than 0.5% of iron, so as to obtain relatively high light transmittance. The layer of low-iron, high-strength, and light-pervious material 23 also protects the package 22 against direct contact with external air while effectively isolates the package 22 from external moisture and dust, enabling the solar cell to have prolonged usable life.

With the above arrangements, the concentration solar cell chip packaging structure formed in the method of the present invention may be completed with simplified process, shortened processing time, and improved processing quality. Therefore, the packaged solar cell provided by the present invention has increased light transmittance and is therefore superior to the solar cell package of prior art.

The present invention has been described with a preferred embodiment thereof and it is understood that many changes and modifications in the described embodiment can be carried out without departing from the scope and the spirit of the invention that is intended to be limited only by the appended claims.

## Claims

1. A concentration solar cell chip packaging structure, comprising:
a heat sink 25;
a thin layer of insulating material 24 provided on a top of the heat sink 25;
an electrically conducting plate 20 provided on the insulating layer 24;
at least one solar cell chip 21 mounted to a top of the conducting plate 20 to electrically connect to the latter;
a package 22 made of a highly light-pervious and shock-absorbing polymer material for encapsulating the solar cell chip 21 and the conducting plate 20; and
a layer of low-iron, high-strength, and light-pervious material 23 attached to an outer surface of the polymer package 22.

2. The concentration solar cell chip packaging structure as claimed in claim 1, wherein the conducting plate 20 is a metal core printed circuit board.

3. The concentration solar cell chip packaging structure as claimed in claim 1, wherein the polymer package 22 is EVA.

4. The concentration solar cell chip packaging structure as claimed in claim 1, wherein the layer of low-iron, high-strength, and light-pervious material 23 contains less than 0.5% of iron.

5. The concentration solar cell chip packaging structure as claimed in claim 4, wherein the layer of low-iron, high-strength, and light-pervious material 23 is tempered glass.

6. A method of forming a concentration solar cell chip packaging structure, comprising the steps of:
providing a heat sink 25;
providing a thin layer of insulating material 24 on a top of the heat sink 25;
providing an electrically conducting plate 20 on the insulating layer ;
providing at least one solar cell chip 21, and mounting the solar cell chip 21 to a top of the conducting plate 20 to electrically connect thereto;
forming a package 22 of a highly light-pervious and shock-absorbing polymer material for encapsulating the conducting plate 20 and the solar cell chip 21; and
providing a layer of low-iron, high-strength, and light-pervious material 23 for attaching to an outer surface of the polymer package 22.

7. The method of forming a concentration solar cell chip packaging structure as claimed in claim 6, wherein the conducting plate 20 is a metal core printed circuit board.

8. The method of forming a concentration solar cell chip packaging structure as claimed in claim 6, wherein the layer of low-iron, high-strength, and light-pervious material 23 contains less than 0.5% of iron.

9. The method of forming a concentration solar cell chip packaging structure as claimed in claim 8, wherein the layer of low-iron, high-strength, and light-pervious material 23 is tempered glass.

10. The method of forming a concentration solar cell chip packaging structure as claimed in claim 6, wherein the highly light-pervious and shock-absorbing polymer package 22 is EVA.
